# FASCICULE DE BREVET EUROPEEN

(11) **EP 1 843 355 B1**
(45) Date de publication et mention de la délivrance du brevet: **19.01.2011**
(21) Numéro de dépôt: 07005342.6
(22) Date de dépôt: 15.03.2007
(51) Int. Cl.: G11C 7/20

(54) **Procédé d'initialisation d'une mémoire**
Verfahren zur Initialisierung einer Speichereinrichtung
A method for initialising a memory

(30) Priorité: 07.04.2006 FR 0603076
(43) Date de publication de la demande: 10.10.2007
(73) Titulaire: STMICROELECTRONICS SA, 92120 Montrouge (FR)
(72) Inventeur: Ganivet, Philippe, 13320 Bouc Bel Air (FR); Murillo, Laurent, Les Olives 13013 Marseille (FR)
(74) Mandataire: de Roquemaurel, Bruno

(56) Documents cités:
- US-A1- 2003 133 338

## Description

La présente invention concerne les mémoires, et notamment les mémoires non volatiles telle que les mémoires EEPROM (Electrically Erasable Programmable Read Only Memory) ou Flash.

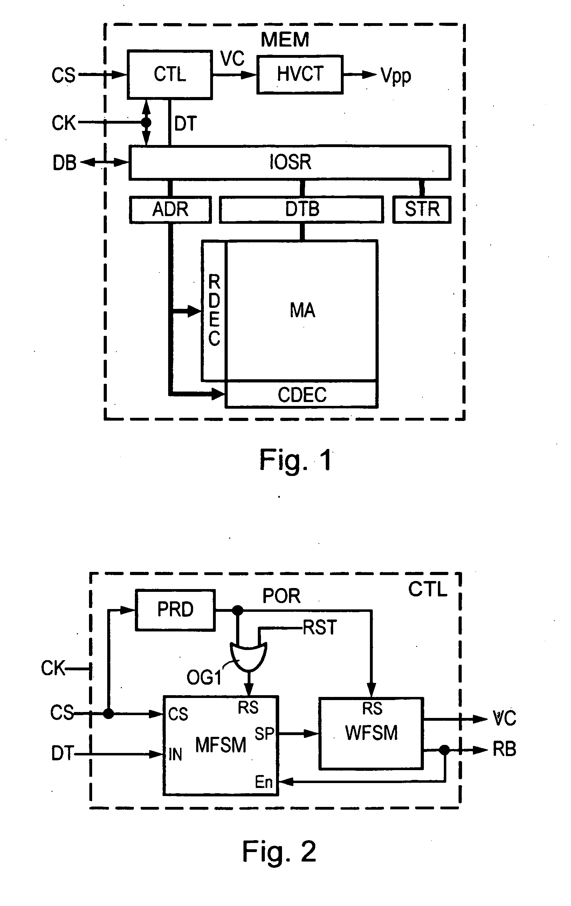

La présente invention s'applique plus particulièrement aux mémoires accessibles par un bus série tel qu'un bus SPI (Serial Peripheral Interface) ou un bus I2C. Un exemple d'une mémoire accessible par un bus série est représenté sur la figure 1. La mémoire MEM représentée sur la figure 1 comprend un plan mémoire MA, un dispositif de contrôle CTL, un circuit survolteur HVCT, un registre d'adresse ADR, un registre de donnée DTB, un registre d'entrée/sortie IOSR, un registre d'état STR, un décodeur de ligne RDEC et un décodeur de colonne CDEC.

Le dispositif de contrôle CTL reçoit de l'extérieur un signal de sélection CS de la mémoire MEM et un signal d'horloge CK. Le dispositif CTL commande le registre IOSR et le registre d'état STR, et fournit un signal de commande VC du circuit HVCT. Le circuit HVCT fournit une haute tension Vpp nécessaire à la programmation et à l'effacement de cellules mémoires du plan mémoire MA. Le registre IOSR reçoit des commandes et échange des données avec l'extérieur de la mémoire par l'intermédiaire d'un bus série DB. Le registre IOSR est cadencé par le signal d'horloge CK et reçoit les commandés, les données et les adresses transmises par le bus. En mode d'écriture, le registre ADR reçoit de l'extérieur par le bus série DB et le registre IOSR une adresse de cellules mémoire à lire, programmer ou effacer, et le registre DTB des données à mémoriser dans le plan mémoire MA. Le registre d'état contient des informations relatives à l'état de la mémoire MEM. L'adresse contenue dans le registre ADR est utilisée pour commander les décodeurs RDEC et CDEC qui permettent de sélectionner des cellules mémoire à programmer, à effacer ou à lire en fonction de l'adresse fournie par le registre d'adresse.

La mémoire est accessible par l'intermédiaire de commandes de lecture et d'écriture. Les commandes appliquées à la mémoire sont décodées à l'aide d'une machine d'état à états finis intégrée au sein du dispositif de contrôle CTL.

Un exemple de dispositif de contrôle CTL est représenté sur la figure 2. Sur la figure 2, le dispositif de contrôle CTL comprend une entrée de signal d'horloge CK, une machine d'état principale MFSM, une machine d'état d'écriture WFSM et un circuit de détection de la mise sous tension de la mémoire PRDT générant un signal d'initialisation POR à la mise sous tension de la mémoire.

La machine d'état MFSM assure notamment le décodage des commandes appliquées à la mémoire, et l'activation de la machine d'état d'écriture WFSM lorsque la commande reçue est une commande d'écriture. La machine d'état WFSM fournit le signal VC assurant notamment le pilotage du circuit survolteur HVCT durant les phases d'écriture de la mémoire. Le circuit PRDT active le signal POR à la suite de la mise sous tension de la mémoire (lorsque la tension d'alimentation dépasse une certaine valeur de seuil). La machine d'état MFSM reçoit le signal de sélection CS de la mémoire MEM, et le signal de commande série DT transmis par le bus DB d'accès à la mémoire. La machine d'état MFSM reçoit également par l'intermédiaire d'une porte logique OG1 de type OU le signal d'initialisation POR et un autre signal d'initialisation RST. Le signal RST comporte une impulsion à chaque front descendant du signal CS. La machine d'état MFSM fournit à la machine d'état WFSM un signal de début d'écriture SP lors de l'exécution d'une commande d'écriture.

La machine d'état WFSM est également initialisée par le signal POR et fournit à la machine d'état MFSM un signal d'occupation RB indiquant lorsqu'une phase d'écriture est en cours. Le signal RB est appliqué à une entrée d'activation En de la machine d'état MFSM. Lorsque le signal RB est actif, la machine d'état MFSM est bloquée, mais peut quand même recevoir et traiter une commande appliquée à la mémoire.

Généralement les machines d'état MFSM et WFSM sont réalisées à l'aide de réseaux logiques programmables PLA (Programmable Logic Array). Les machines d'état sont initialisées à l'aide du signal POR à la mise sous tension de la mémoire MEM. En outre, le réseau logique programmable de la machine d'état MFSM est initialisée par le signal RST au début de chaque accès à la mémoire afin de toujours démarrer dans un même état bien défini. Le circuit logique autour des machines d'état doit également être initialisé dans un même état bien défini pour fonctionner correctement.

Cependant, en raison de certaines contraintes de protocole notamment, certaines parties du dispositif CTL ne peuvent pas être initialisées au début de la réception d'une commande. Ainsi, le signal d'initialisation RST ne peut pas être appliqué à la machine d'état WFSM étant donné que les commandes d'écriture dans la mémoire sont exécutées à la suite de la désélection de la mémoire (remontée du signal CS).

Si pour une raison quelconque (perturbation sur la tension d'alimentation, une décharge électrostatique, défaillance de cellules mémoire, etc.), le dispositif CTL est placé dans un état interdit, la mémoire ne peut plus fonctionner correctement et la fiabilité des accès ultérieurs à la mémoire se trouve affectée.

En particulier, lorsque la mémoire est commandée en écriture, la machine d'état WFSM émet le signal d'occupation RB qui bloque la machine d'état principale MFSM tant que l'opération d'écriture ne s'est pas terminée. Tant que le signal d'occupation RB est actif, l'initialisation du dispositif de contrôle CTL qui est normalement effectuée à chaque nouvel accès à la mémoire n'est pas exécutée à la suite d'un changement d'état du signal CS (le signal RST n'est pas généré). Si une opération d'écriture dans la mémoire ne s'est pas correctement déroulée, le signal d'occupation RB peut rester actif. Il en résulte alors que la mémoire est bloquée. Le seul moyen de rétablir la mémoire dans un état normal est de couper temporairement l'alimentation de la mémoire. Dans des applications comme l'automobile, il n'est pas acceptable de devoir couper l'alimentation pour réinitialiser des circuits. Même si la mémoire n'est plus fonctionnelle, elle doit pouvoir encore exécuter des commandes de lecture.

Le document US 2003/0133338 décrit un circuit d'initialisation d'un circuit intégré tel qu'une mémoire non volatile. Ce circuit d'initialisation est configuré pour initialiser un circuit en fonction d'une tension d'alimentation, et pour placer le circuit à l'état occupé pendant l'exécution de l'initialisation.

D'une manière générale, la présente invention a pour objectif de réduire les risques de mauvais fonctionnement du dispositif de contrôle d'une mémoire en prévoyant d'effectuer une initialisation du dispositif de contrôle aussi complète que celle obtenue par une mise hors tension du circuit.

Un objectif de la présente invention est de prévoir une mémoire dont le dispositif de contrôle peut être initialisé complètement sans mise hors tension du circuit.

Un autre objectif de la présente invention est de prévoir une mémoire dont le dispositif de contrôle est capable d'exécuter une commande d'initialisation complète, tout en restant compatible avec le protocole de communication de la mémoire avec l'extérieur.

Ces objectifs sont atteints par la prévision d'un procédé d'initialisation d'un dispositif de contrôle d'une mémoire, le dispositif de contrôle exécutant des commandes d'accès à la mémoire transmises à la mémoire par un signal de commande, le procédé comprenant des étapes de détection de la mise sous tension de la mémoire et d'initialisation au moins partielle du dispositif de contrôle à la suite de la mise sous tension de la mémoire.

Selon l'invention, le procédé comprend des étapes de détection d'un événement particulier dans le signal de commande, et d'initialisation au moins partielle du dispositif de contrôle à la suite de la détection de l'événement particulier.

Selon un mode de réalisation de l'invention, le procédé comprend une étape d'initialisation d'un circuit d'initialisation détectant l'événement particulier, à la suite de l'initialisation du dispositif de contrôle.

Selon un mode de réalisation de l'invention, l'événement particulier est une commande d'initialisation reçue par la mémoire.

Selon un mode de réalisation de l'invention, l'événement particulier est une commande d'écriture ou de lecture dans la mémoire, non associée à une adresse d'écriture ou de lecture.

Selon un mode de réalisation de l'invention, une commande d'écriture ou de lecture reçue par la mémoire est considérée comme une commande d'initialisation si un signal de sélection de la mémoire change d'état avant qu'une adresse d'écriture ou de lecture soit reçue par la mémoire, à la suite de la réception de la commande de lecture ou d'écriture.

Selon un mode de réalisation de l'invention, le procédé comprend une étape d'initialisation au moins partielle du dispositif de contrôle si une commande d'écriture dans la mémoire est toujours en cours d'exécution à l'issue d'une période maximum d'écriture.

Selon un mode de réalisation de l'invention, l'initialisation au moins partielle du dispositif de contrôle comprend l'initialisation d'une machine d'état principale et d'une machine d'état d'écriture.

L'invention concerne également une mémoire comprenant un dispositif de contrôle pour exécuter des commandes d'accès à la mémoire, reçues dans un signal de commande appliqué à la mémoire, et un circuit de détection de la mise sous tension de la mémoire initialisant au moins partiellement le dispositif de contrôle à la suite de la mise sous tension de la mémoire.

Selon l'invention, la mémoire comprend un circuit d'initialisation détectant un événement particulier dans le signal de commande, et initialisant au moins partiellement le dispositif de contrôle, à la suite de la détection de l'événement particulier.

Selon un mode de réalisation de l'invention, le circuit d'initialisation se réinitialise au moins partiellement à la suite de l'initialisation du dispositif de contrôle.

Selon un mode de réalisation de l'invention, l'événement particulier est une commande d'initialisation reçue par la mémoire.

Selon un mode de réalisation de l'invention, l'événement particulier est une commande d'écriture ou de lecture dans la mémoire, non associée à une adresse d'écriture ou de lecture.

Selon un mode de réalisation de l'invention, la mémoire comprend un circuit pour détecter la réception d'une commande d'écriture ou de lecture par la mémoire, suivie d'un changement d'état d'un signal de sélection de la mémoire, avant qu'une adresse d'écriture ou de lecture soit reçue par la mémoire.

Selon un mode de réalisation de l'invention, la mémoire comprend un circuit de temporisation qui est déclenché au début de l'exécution d'une commande d'écriture dans la mémoire et qui initialise au moins partiellement le dispositif de contrôle à l'issue d'une période maximum d'écriture.

Selon un mode de réalisation de l'invention, la partie du dispositif de contrôle qui est initialisée comprend une machine d'état principale et une machine d'état d'écriture.

Ces objets, caractéristiques et avantages ainsi que d'autres de la présente invention seront exposés plus en détail dans la description suivante de modes de réalisation de l'invention, faite à titre non limitatif en relation avec les figures jointes parmi lesquelles :
- la figure 1 déjà décrite représente sous la forme de blocs une mémoire EEPROM accessible par un bus série,
- la figure 2 déjà décrite représente sous la forme de blocs un dispositif classique de contrôle de la mémoire,
- la figure 3 représente sous la forme de blocs un dispositif de contrôle d'une mémoire, selon l'invention,
- les figures 4 et 5 sont des schémas électriques de circuits de génération de signaux d'initialisation, du dispositif de contrôle selon l'invention,
- les figures 6 et 7 sont des chronogrammes de signaux électriques illustrant le fonctionnement du dispositif de contrôle selon l'invention,
- la figure 8 est un schéma électrique d'un circuit de génération d'un signal d'initialisation, du dispositif de contrôle selon l'invention.

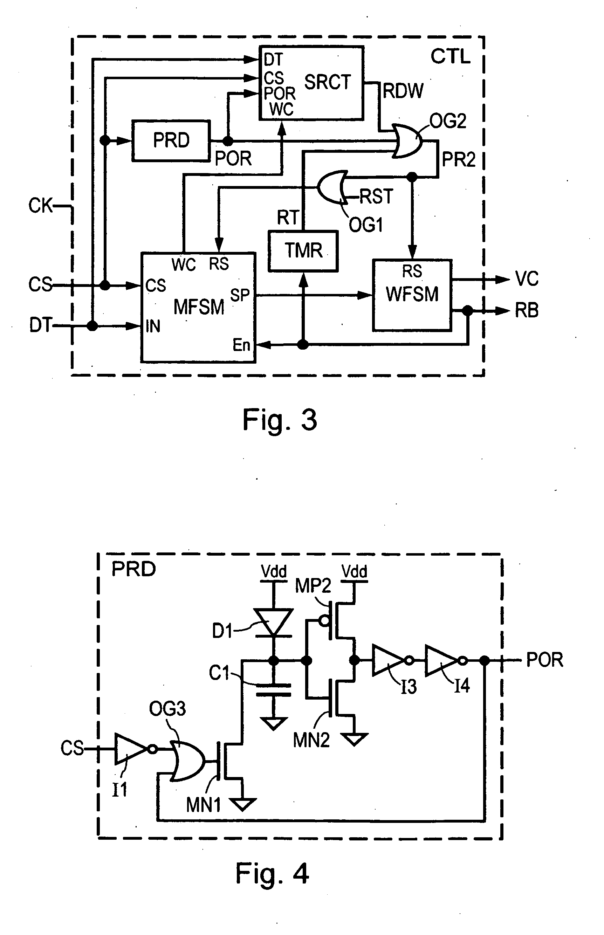

La figure 3 représente un dispositif de contrôle selon l'invention, de la mémoire MEM représentée sur la figure 1. Sur la figure 3, le dispositif de contrôle CTL comprend une entrée de signal d'horloge CK, une machine d'état principale MFSM, une machine d'état d'écriture WFSM et un circuit de détection de la mise sous tension de la mémoire PRDT générant un signal d'initialisation POR.

La machine d'état MFSM assure notamment le décodage des commandes appliquées à la mémoire. La machine d'état WFSM fournit le signal VC assurant le pilotage du circuit survolteur HVCT durant les phases d'écriture de la mémoire. Le circuit PRDT active le signal POR à la suite de la mise sous tension de la mémoire (lorsque la tension d'alimentation Vdd dépasse une certaine valeur de seuil). La machine d'état MFSM reçoit le signal de sélection CS de la mémoire MEM, et le signal de commande série DT transmis par le bus DB d'accès à la mémoire. La machine d'état MFSM reçoit également par l'intermédiaire d'une porte logique OG1 de type OU le signal d'initialisation POR et un autre signal d'initialisation RST utilisé pour initialiser un réseau logique programmable PLA de la machine d'état MFSM au début de chaque accès à la mémoire MEM. Le signal RST comporte une impulsion à chaque front descendant du signal CS. La machine d'état MFSM fournit à la machine d'état WFSM un signal de début d'écriture SP lors de l'exécution d'une commande d'écriture.

La machine d'état WFSM est également initialisée par le signal POR et fournit à la machine d'état MFSM un signal d'occupation RB indiquant qu'une phase d'écriture est en cours. Le signal RB est appliqué à une entrée d'activation En de la machine d'état MFSM. Lorsque le signal RB est actif, la machine d'état MFSM est bloquée, mais peut quand même recevoir une commande envoyée à la mémoire après l'activation du signal RB.

Selon l'invention, le dispositif de contrôle CTL comprend un circuit de génération d'un signal d'initialisation SRCT, qui applique un signal d'initialisation RDW aux machines d'état MFSM et WFSM.

Plus précisément, le circuit SRCT génère le signal d'initialisation RDW à la suite de la réception d'un signal de commande WC. Le signal RDW est appliqué aux machines d'état MFSM et WFSM par l'intermédiaire d'une porte logique OG2 de type OU dont une autre entrée reçoit le signal POR de sortie du circuit PRDT. Le signal de sortie PR2 de la porte OG2 est appliqué à une entrée d'initialisation RS des machines d'état MFSM et WFSM. Le signal WC est émis par la machine d'état MFSM lorsqu'un événement particulier est détecté dans le signal de commande série DT.

Par exemple, si les commandes appliquées à la mémoire sont transmises conformément au protocole SPI, les commandes comportent 8 bits, et sont répertoriées dans le tableau suivant :

**Tableau 1**

| Commande | Code de commande | Description |
|---|---|---|
| WREN | 06h | Autorisation d'écriture |
| RDSR | 05h | Lecture du registre d'état SR |
| WRDI | 04h | Interdiction d'écriture |
| READ | 03h | Lecture d'une donnée dans la mémoire |
| WRITE | 02h | Ecriture d'une donnée dans la mémoire |
| WRSR | 01h | Ecriture dans le registre d'état SR |

Les commandes d'écriture WRITE et de lecture READ dans la mémoire sont suivies d'une adresse d'écriture ou de lecture, puis de la donnée à écrire dans le cas d'une commande d'écriture. La commande d'écriture dans le registre d'état SR est suivie de la donnée à écrire dans le registre d'état. Les commandes, les adresses et les données sont transmises en commençant par le bit de poids fort. Les transmissions commencent lors de l'apparition d'une transition vers 0 du signal de sélection CS et se terminent à la remontée vers 1 du signal CS.

Pour déclencher une initialisation du dispositif de contrôle CTL, l'invention utilise une commande normalement suivie d'une adresse ou d'une donnée, sans que cette commande soit suivie d'une adresse ou d'une donnée à écrire. Dans le tableau 1, les commandes susceptibles d'être utilisées pour déclencher une initialisation sont WRITE, READ et WRSR. Autrement dit, si le dispositif de contrôle reçoit une telle commande et que le signal de sélection CS repasse à 1 à la fin de la réception des huit bits de la commande, le dispositif de contrôle considère qu'il s'agit d'une commande d'initialisation.

De cette manière, l'invention prévoit une commande supplémentaire d'initialisation tout en restant compatible avec le protocole de transmission des commandes à la mémoire MEM.

Dans l'exemple du protocole SPI, le signal WC généré par la machine d'état MFSM est synchrone de la commande reçue. Si la commande reçue par la machine d'état est la commande choisie pour l'initialisation du circuit, le signal WC est identique aux sept premiers bits de la commande reçue. Ainsi, si la commande d'initialisation choisie est la commande WRITE (= 02h), le signal WC est à 0 pendant les cinq premiers fronts descendants du signal d'horloge CK et comporte une impulsion à 1 entre les sixième et septième fronts descendants du signal d'horloge si les 6 premiers bits (bits 7 à 2) de la commande reçue sont à 0 et si le septième bit (bit 1) de la commande reçue est à 1.

La figure 4 représente un exemple de réalisation du circuit de génération PRDT. Le circuit PRDT comprend une porte OU OG3 recevant le signal de sélection CS de la mémoire, préalablement inversé par un inverseur I1. La sortie de la porte OG3 est connectée à la grille d'un transistor MOS à canal N MN1. La source du transistor MN1 est connectée à la masse. Le circuit PRDT comprend un comparateur de la tension d'alimentation Vdd à un seuil de tension. A cet effet, le comparateur comporte une diode D1 définissant le seuil de tension et dont l'anode est connectée à la source de tension d'alimentation Vdd. La cathode de la diode est reliée à la masse par l'intermédiaire d'un condensateur C1, et est connectée au drain du transistor MN1, à la grille d'un transistor MOS à canal P MP2, et à la grille d'un transistor MOS à canal N MN2. La source du transistor MP2 reçoit la tension d'alimentation Vdd. La source du transistor MN2 est connectée à la masse. Les drains des transistors MN2 et MP2 sont connectés à l'entrée d'un inverseur I3 dont la sortie fournit le signal d'initialisation POR par l'intermédiaire d'un autre inverseur I4. Le signal d'initialisation POR est appliqué à une entrée de la porte OG3. Le seuil de tension est déterminé par la tension de seuil de la diode D1.

Le signal POR généré par le circuit PRDT présente une impulsion d'initialisation lorsque la tension d'alimentation Vdd de la mémoire franchit le seuil de tension. La porte OG3 et les inverseurs I3 et I4 permettent de réduire la largeur de l'impulsion d'initialisation du signal POR.

Il est à noter que la diode D1 peut être remplacée par plusieurs diodes montées en série pour ajuster le seuil de tension.

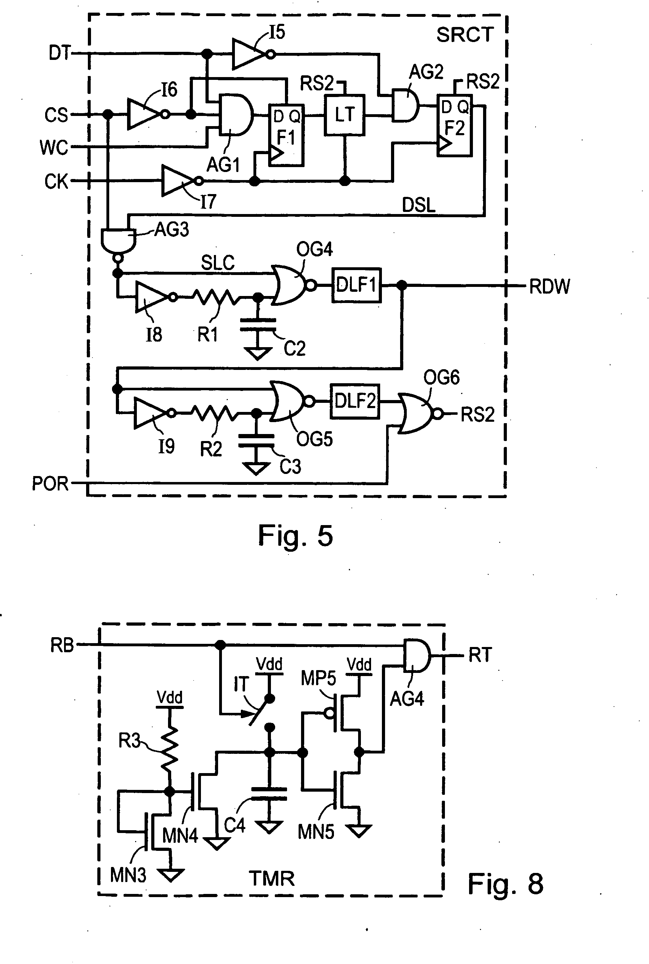

La figure 5 représente un exemple de circuit de génération d'un signal d'initialisation SRCT lorsque la commande d'initialisation choisie est la commande WRITE. Le circuit SRCT comprend une porte logique AG1 de type ET recevant le signal de commande série DT appliqué à la mémoire, le signal de sélection CS préalablement inversé par un inverseur I6, et le signal WC provenant de la machine d'état MFSM et indiquant si un événement particulier est détecté dans le signal de commande série. Dans le cas du protocole SPI, si cet événement est détecté (réception d'une commande WRITE), le signal WC est à 0 et comporte une impulsion entre le sixième et le septième front descendant du signal d'horloge CK, à compter du passage à 0 du signal CS.

La sortie de la porte AG1 est connectée à l'entrée D d'une bascule D (flip-flop) F1. La bascule F1 est initialisée par le signal CS inversé en sortie de l'inverseur I6. La sortie Q de la bascule F1 est connectée à l'entrée d'un verrou LT. La sortie du verrou LT est connectée à l'entrée d'une porte logique de type ET AG2 recevant sur une autre entrée le signal de commande DT préalablement inversé par un inverseur I5. La sortie de la porte AG2 est connectée à l'entrée D d'une bascule D F2 dont la sortie Q fournit un signal DSL. Les bascules F1 et F2 et le verrou LT sont cadencés par le signal d'horloge CK préalablement inversé par un inverseur 17.

Le signal DSL est appliqué avec le signal CS à une porte logique AG3 de type ET inversée. Le signal SLC en sortie de la porte AG3 est appliqué à l'entrée d'une porte logique OG4 de type OU inversé. Le signal SLC est également appliqué à un circuit RC par l'intermédiaire d'un inverseur 18. Le circuit RC comprend une résistance R1 connectée d'un côté à la sortie de l'inverseur 18 et de l'autre à une entrée de la porte OG4 et à un condensateur C2 connecté par ailleurs à la masse. La sortie de la porte OG4 est connectée à l'entrée d'un circuit de retard de front descendant DLF1 dont la sortie fournit le signal RDW. Le circuit DLF1 applique un retard aux fronts descendants du signal appliqué en entrée.

Le signal RDW est appliqué à l'entrée d'une porte OG5 de type OU inversé et à un circuit RC par l'intermédiaire d'un inverseur 19. Le circuit RC comprend une résistance R2 connectée d'un côté à la sortie de l'inverseur I9 et de l'autre à une entrée de la porte OG5 et à un condensateur C3 connecté par ailleurs à la masse. La sortie de la porte OG5 est connectée à l'entrée d'un circuit de retard de front descendant DLF2 dont la sortie est connectée à l'entrée d'une porte OG6 de type OU inversé. Le signal POR est appliqué à une autre entrée de la porte OG6. La sortie de la porte OG6 fournit un signal d'initialisation. RS2 qui est appliqué aux entrées d'initialisation du verrou LT et de la bascule F2.

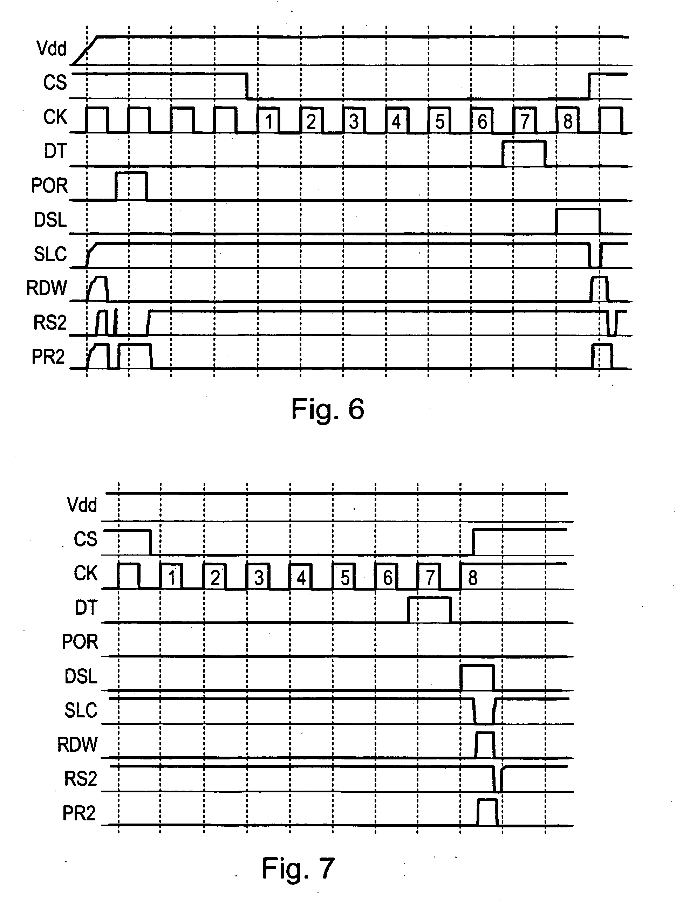

Le fonctionnement du dispositif de contrôle CTL est illustré par des chronogrammes représentés sur les figures 6 et 7. Les figures 6 et 7 représentent les chronogrammes des signaux Vdd, CS, CK, DT, POR, DSL, SLC, RDW, RS2 et PR2 lorsqu'une commande d'initialisation est reçue par le dispositif de contrôle CTL.

La figure 6 illustre une initialisation de la mémoire à la suite de la mise sous tension de celle-ci. A la mise sous tension, la tension d'alimentation Vdd augmente progressivement jusqu'à atteindre sa valeur nominale. Le signal de sélection CS est à 1. Le signal de commande DT est à 0. La montée de la tension d'alimentation Vdd (mise sous tension de la mémoire MEM), tandis que le signal de sélection CS est à 1, déclenche l'apparition d'une impulsion dans le signal POR émis par le circuit PRDT.

Les figures 6 et 7 illustrent la réception d'une commande d'initialisation par la mémoire. Si la commande transmise par le signal DT est une commande d'initialisation, c'est-à-dire une commande d'écriture WRITE (= 02h) non suivie d'une adresse et d'une donnée, elle reste à 0 jusqu'au sixième front descendant du signal d'horloge CK et comporte une impulsion au septième front descendant du signal CK avant de repasser à 0 au huitième front descendant du signal CK, précédant la remontée du signal CS. Par conséquent, durant les six premiers fronts descendants du signal d'horloge CK, la sortie de la porte AG1 reste à 0. Il en résulte que durant cette période, la bascule F1 reste à l'état 0 et la valeur mémorisée par le verrou LT est 0. Si le signal WC présente une impulsion (au sixième front descendant du signal d'horloge), le signal DT est également à 1 à cet instant. La sortie de la porte AG1 passe donc à 1. La bascule F1 change alors d'état et fournit en sortie un signal à 1. Cette valeur de signal est mémorisée par le verrou LT. Comme le signal DT est à 1 et est inversé par l'inverseur I5, la sortie de la porte AG2 reste à 0. L'état de la bascule F2 est également à 0. Ensuite, le dernier bit de la commande est appliqué en entrée de l'inverseur 15. Si le dernier bit de la commande reçue est à 0, la sortie de la porte AG2 passe à 1, de même que la bascule F2. Dans le cas contraire, la bascule F2 reste à l'état 0. Par conséquent, le signal de sortie DSL de la bascule F2 est à 1 lorsque la commande appliquée en entrée est égale à 02h. Le signal DSL reste à 1 jusqu'au front montant du signal d'horloge CK suivant le passage à 1 du signal de sélection CS. Dans l'intervalle entre la montée du signal CS et la descente du signal DSL, le signal de sortie SLC de la porte AG3, normalement à 1, passe à 0. Il en résulte que la sortie de la porte OG4 passe à 1 jusqu'à un certain seuil de charge du condensateur C2. Le signal RDW passe à 1 en même temps que le signal de sortie de la porte OG4. Le passage à 0 du signal RDW est retardé par le circuit DLF1 par rapport au passage à 1 du signal SLC. Le retard appliqué par le circuit DLF1 est ajusté pour obtenir une certaine largeur de l'impulsion du signal RDW.

Le circuit formé de la porte OG4, de l'inverseur 18 et du circuit RC R1, C2 permet donc de générer en sortie une impulsion sur changement d'état du signal SLC. Le signal RDW comporte ainsi une impulsion d'initialisation si la commande reçue est une commande d'écriture immédiatement suivie (au neuvième bit de la commande) de la remontée du signal CS. Le signal d'initialisation PR2 généré à partir du signal RDW notamment, est donc actif à la suite de la remontée à 1 du signal de sélection CS.

Il est à noter que la bascule F1 est initialisée lors de la remontée du signal CS. Cette initialisation n'a pas d'influence sur la valeur du signal RDW car celle-ci est déterminée à partir de l'état du verrou LT et de la bascule F2 qui ne sont pas encore initialisés.

Le signal RDW est utilisé pour générer le signal d'initialisation RS2. Lorsque le signal RDW est à 0, le signal RS2 est à 1. Lorsque le signal RDW passe à 1, la sortie de la porte OG5 reste à 0 et donc le signal RS2 reste à 1. Lorsque le signal RDW repasse à 0, la sortie de la porte OG5 passe à 1 et donc le signal RS2 passe à 0 avec un certain retard appliqué par le circuit DLF2 et reste à 0 pendant le temps de charge du condensateur C3.

Le circuit formé de la porte OG5, de l'inverseur I9 et du circuit RC R2, C3 permet de générer une impulsion d'initialisation immédiatement après l'impulsion d'initialisation du signal RDW. Le signal RS2 ainsi généré comporte une impulsion permettant d'initialiser le verrou LT et la bascule F2 immédiatement après l'initialisation du circuit de contrôle CTL. Le retard appliqué par le circuit DLF2 est ajusté pour augmenter la largeur de l'impulsion d'initialisation du signal RS2 et pour que cette impulsion n'apparaisse qu'à la suite de la retombée du signal RDW.

Il est à noter qu'à la mise sous tension du circuit SRCT, des impulsions apparaissent dans les signaux RDW et RS2. Ces impulsions ne perturbent pas le fonctionnement du circuit puisqu'elles sont générées pendant une période où la mémoire MEM n'est pas sélectionnée, et avant la génération du signal d'initialisation POR.

La figure 7 illustre en particulier le cas où le signal d'horloge CK reste à l'état haut à la suite de la remontée du signal de sélection CS, c'est-à-dire au huitième coup d'horloge à la suite du passage à 0 du signal CS. La figure 7 montre que l'absence de neuvième coup d'horloge n'empêche pas la génération d'une impulsion d'initialisation dans le signal RDW. En effet, le passage à 1 du signal RDW est déclenché par le huitième coup d'horloge et le passage à 0 du signal RDW est lié à la désélection de la mémoire (passage à 1 du signal CS).

Dans un mode de réalisation préféré de l'invention illustré par la figure 3, le dispositif de contrôle comprend un circuit de temporisation TMR. Le circuit de temporisation est déclenché au début de l'exécution d'une commande d'écriture dans la mémoire MEM par le passage à 1 du signal RB. La durée de la temporisation est choisie légèrement supérieure au temps d'écriture d'un mot dans la mémoire, par exemple 10 ms. Si la temporisation arrive à échéance avant que le signal RB passe à 0, le circuit TMR émet un signal RT qui est appliqué à une entrée de la porte OG2 pour déclencher une initialisation du dispositif de contrôle CTL.

Un exemple de circuit de temporisation est représenté sur la figure 8. Le circuit de temporisation TMR comprend un transistor MOS à canal N MN3 monté en diode, c'est-à-dire dont la grille est connectée au drain. Le drain du transistor MN3 est également relié à la source de tension d'alimentation Vdd par l'intermédiaire d'une résistance R3, et la source de ce transistor est connectée à la masse. Le drain du transistor MN3 est également connecté à la grille d'un transistor MOS à canal N MN4 dont la source est connectée à la masse. Le drain du transistor MN4 est relié à la masse par l'intermédiaire d'un condensateur C4 et à la source de tension d'alimentation Vdd par l'intermédiaire d'un interrupteur IT. L'interrupteur IT est commandé par le signal RB et est fermé lorsque le signal RB est à 0. Le drain du transistor MN4 est connecté à la grille d'un transistor MOS à canal P MP5 et à la grille d'un transistor MOS à canal N MN5. La source du transistor MP5 est connectée à la source de tension d'alimentation Vdd. La source du transistor MN5 est connectée à la masse. Les drains des transistors MP5 et MN5 sont connectés à l'entrée d'une porte logique AG4 de type ET dont une autre entrée reçoit le signal RB et dont la sortie fournit le signal d'initialisation RT.

Lors de l'initialisation du circuit, le signal RB est à 0 et donc l'interrupteur IT est fermé. Il en résulte que le condensateur C4 est chargé. Le signal de sortie de l'inverseur formé par les transistors MP5 et MN5 est donc à 0. Par conséquent, le signal RT est à 0.

Lorsque le signal RB passe à 1 au début de l'exécution d'une commande de lecture, l'interrupteur IT est ouvert. Il en résulte que le condensateur C4 se décharge au travers du transistor MN4. La durée de la décharge du condensateur est ajustée par la polarisation du transistor MN3. Si le signal RB passe à 0 avant que la tension aux bornes du condensateur C4 descende en dessous de la tension de seuil du transistor MN5, l'interrupteur IT se ferme et le condensateur est à nouveau chargé. Dans le cas contraire, le signal appliqué à la porte AG4 par l'inverseur formé par les transistors MP5, MN5 passe à 1. Si le signal RB est toujours à 1, le signal RT émis par le circuit de temporisation TMR passe à 1, ce qui déclenche l'initialisation des machines d'état MFSM et WFSM. Il en résulte que le signal RB repasse à 0, ce qui annule le signal RT.

La prévision du circuit de temporisation TMR permet d'éviter les cas de blocage de la mémoire qui ne seraient pas évités avec le circuit SRCT.

Il apparaîtra clairement à l'homme de l'art que la présente invention est susceptible de diverses variantes de réalisation et d'applications. En particulier, l'invention n'est pas limitée aux mémoires accessibles par un bus SPI. Elle s'applique plus généralement à toute mémoire accessible par un bus série.

L'événement déclencheur de l'initialisation du circuit de contrôle ne figure pas nécessairement dans le signal de donnée appliqué à la mémoire. Cet événement peut être détecté dans un autre signal appliqué à la mémoire pour déclencher une initialisation de la mémoire équivalente à celle qui est effectuée à la mise sous tension. Lorsque cet événement est détecté dans le signal de donnée, tout autre événement que la réception d'une commande d'écriture ou de lecture peut être utilisé pour déclencher l'initialisation du circuit de contrôle. Il peut par exemple s'agir d'une commande spécifique. Par exemple, comme les commandes prévues dans le protocole SPI commencent par un 0 durant cinq cycles d'horloge, on peut prévoir que la commande d'initialisation commence par un 1 pendant un ou plusieurs cycles d'horloge.

Par ailleurs, il est à noter que l'initialisation partielle du circuit d'initialisation SRCT, à la suite de l'initialisation des machines d'état du circuit de contrôle n'est prévue qu'en raison de la nature de la commande d'initialisation à détecter. En effet, cette initialisation du circuit SRCT n'est nécessaire qu'en raison de la présence de la bascule F2 et du verrou LT que l'on ne peut initialiser qu'après avoir généré le signal d'initialisation RDW.

## Revendications

1. Procédé d'initialisation d'un dispositif de contrôle (CTL) d'une mémoire (MEM), le dispositif de contrôle exécutant des commandes d'accès à la mémoire transmises à la mémoire par un signal de commande (DT), le procédé comprenant des étapes de détection de la mise sous tension de la mémoire et d'initialisation au moins partielle du dispositif de contrôle à la suite de la mise sous tension de la mémoire,
**caractérisé en ce qu'**il comprend des étapes de détection d'un événement particulier dans le signal de commande (DT), et d'initialisation au moins partielle du dispositif de contrôle (CTL) à la suite de la détection de l'événement particulier.

2. Procédé selon la revendication 1, comprenant une étape d'initialisation d'un circuit d'initialisation (SRCT) détectant l'événement particulier, à la suite de l'initialisation du dispositif de contrôle (CTL).

3. Procédé selon la revendication 1 ou 2, dans lequel l'événement particulier est une commande d'initialisation reçue par la mémoire (MEM).

4. Procédé selon l'une des revendications 1 à 3, dans lequel l'événement particulier est une commande d'écriture ou de lecture dans la mémoire (MEM), non associée à une adresse d'écriture ou de lecture.

5. Procédé selon la revendication 4, dans lequel une commande d'écriture ou de lecture reçue par la mémoire (MEM) est considérée comme une commande d'initialisation si un signal de sélection (CS) de la mémoire (MEM) change d'état avant qu'une adresse d'écriture ou de lecture soit reçue par la mémoire, à la suite de la réception de la commande de lecture ou d'écriture.

6. Procédé selon l'une des revendications 1 à 5, comprenant une étape d'initialisation au moins partielle du dispositif de contrôle (CTL) si une commande d'écriture dans la mémoire (MEM) est toujours en cours d'exécution à l'issue d'une période maximum d'écriture.

7. Procédé selon l'une des revendications 1 à 6, dans lequel l'initialisation au moins partielle du dispositif de contrôle (CTL) comprend l'initialisation d'une machine d'état principale (MFSM) et d'une machine d'état d'écriture (WFSM).

8. Mémoire comprenant un dispositif de contrôle (CTL) pour exécuter des commandes d'accès à la mémoire, reçues dans un signal de commande (DT) appliqué à la mémoire (MEM), et un circuit de détection de la mise sous tension de la mémoire (PRDT) initialisant au moins partiellement le dispositif de contrôle à la suite de la mise sous tension de la mémoire,
**caractérisée en ce qu'**elle comprend un circuit d'initialisation (SRCT) détectant un événement particulier dans le signal de commande (DT), et initialisant au moins partiellement le dispositif de contrôle (CTL), à la suite de la détection de l'événement particulier.

9. Mémoire selon la revendication 8, dans laquelle le circuit d'initialisation (SRCT) se réinitialise au moins partiellement à la suite de l'initialisation du dispositif de contrôle (CTL).

10. Mémoire selon la revendication 8 ou 9, dans laquelle l'événement particulier est une commande d'initialisation reçue par la mémoire (MEM).

11. Mémoire selon l'une des revendications 8 à 10, dans laquelle l'événement particulier est une commande d'écriture ou de lecture dans la mémoire (MEM), non associée à une adresse d'écriture ou de lecture.

12. Mémoire selon la revendication 11, comprenant un circuit (SRCT) pour détecter la réception d'une commande d'écriture ou de lecture par la mémoire (MEM), suivie d'un changement d'état d'un signal de sélection (CS) de la mémoire (MEM), avant qu'une adresse d'écriture ou de lecture soit reçue par la mémoire.

13. Mémoire selon l'une des revendications 8 à 12, comprenant un circuit de temporisation (TMR) qui est déclenché au début de l'exécution d'une commande d'écriture dans la mémoire (MEM) et qui initialise au moins partiellement le dispositif de contrôle (CTL) à l'issue d'une période maximum d'écriture.

14. Mémoire selon l'une des revendications 8 à 13, dans laquelle la partie du dispositif de contrôle (CTL) qui est initialisée comprend une machine d'état principale (MFSM) et une machine d'état d'écriture (WFSM).

## Claims

1. A method for initializing a control device (CTL) of a memory (MEM), the control device executing commands for accessing the memory transmitted to the memory by a control signal (DT), the method comprising steps of detecting the switching on of the memory and of at least partially initializing the control device following the switching on of the memory,
**characterized in that** it comprises steps of detecting a specific event in the control signal (DT), and of at least partially initializing the control device (CTL) following the detection of the specific event.

2. Method according to claim 1, comprising a step of initializing an initialization circuit (SRCT) detecting the specific event, following the initialization of the control device (CTL).

3. Method according to claim 1 or 2, wherein the specific event is an initialization command received by the memory (MEM).

4. Method according to one of claims 1 to 3, wherein the specific event is a write or read command for reading or writing in the memory (MEM), not associated with a write or read address.

5. Method according to claim 4, wherein a write or read command received by the memory (MEM) is considered to be an initialization command if a selection signal (CS) for selecting the memory (MEM) changes state before a write or read address is received by the memory, following the receipt of the read or write command.

6. Method according to one of claims 1 to 5, comprising a step of at least partially initializing the control device (CTL) if a write command for writing in the memory (MEM) is still being executed at the end of a maximum write period.

7. Method according to one of claims 1 to 6, wherein the at least partial initialization of the control device (CTL) comprises initializing a main state machine (MFSM) and a write state machine (WFSM).

8. A memory comprising a control device (CTL) for executing commands for accessing the memory, received in a control signal (DT) applied to the memory (MEM), and a detector circuit for detecting the switching on of the memory (PRDT) at least partially initializing the control device following the switching on of the memory,
**characterized in that** it comprises an initialization circuit (SRCT) detecting a specific event in the control signal (DT), and at least partially initializing the control device (CTL), following the detection of the specific event.

9. Memory according to claim 8, wherein the initialization circuit (SRCT) is reset at least partially following the initialization of the control device (CTL).

10. Memory according to claim 8 or 9, wherein the specific event is an initialization command received by the memory (MEM).

11. Memory according to one of claims 8 to 10, wherein the specific event is a command for writing or reading in the memory (MEM), not associated with a write or read address.

12. Memory according to claim 11, comprising a circuit (SRCT) for detecting the receipt of a write or read command by the memory (MEM), followed by a state change in a selection signal (CS) for selecting the memory (MEM), before a write or read address is received by the memory.

13. Memory according to one of claims 8 to 12, comprising a time delay circuit (TMR) that is triggered at the start of the execution of a write command in the memory (MEM) and which at least partially initializes the control device (CTL) at the end of a maximum write period.

14. Memory according to one of claims 8 to 13, wherein the part of the control device (CTL) that is initialized comprises a main state machine (MFSM) and a write state machine (WFSM).

## Patentansprüche

1. Verfahren der Initialisierung einer Prüfvorrichtung (CTL) eines Speichers (MEM), wobei die Prüfvorrichtung Befehle für den Zugriff zum Speicher ausführt, die dem Speicher von einem Steuersignal (DT) übertragen werden, wobei das Verfahren Schritte der Erkennung der Unterspannungssetzung des Speichers und der zumindest partiellen Initialisierung der Prüfvorrichtung nach der Unterspannungssetzung des Speichers umfasst,
**dadurch gekennzeichnet, dass** es Schritte der Erkennung eines besonderen Ereignisses im Steuersignal (DT), und der zumindest partiellen Initialisierung der Prüfvorrichtung (CTL) nach der Erkennung des besonderen Ereignisses umfasst.

2. Verfahren nach Anspruch 1, umfassend einen Schritt der Initialisierung einer Initialisierungsschaltung (SRCT), die das besondere Ereignis nach der Initialisierung der Prüfvorrichtung (CTL) erkennt.

3. Verfahren nach Anspruch 1 oder 2, in dem das besondere Ereignis ein Initialisierungsbefehl ist, der vom Speicher (MEM) empfangen wird.

4. Verfahren nach einem der Ansprüche 1 bis 3, in dem das besondere Ereignis ein Schreib- oder Lesebefehl im Speicher (MEM) ist, der nicht mit einer Schreib- oder Leseadresse verbunden ist.

5. Verfahren nach Anspruch 4, in dem ein Schreiboder Lesebefehl, der vom Speicher (MEM) empfangen wird, als ein Initialisierungsbefehl angesehen wird, wenn ein Auswahlsignal (CS) des Speichers (MEM) den Zustand ändert, bevor nach dem Empfang des Lese- oder Schreibbefehls eine Schreib- oder Leseadresse vom Speicher empfangen wird.

6. Verfahren nach einem der Ansprüche 1 bis 5, umfassend einen Schritt der zumindest partiellen Initialisierung der Prüfvorrichtung (CTL) wenn ein Schreibbefehl im Speicher (MEM) nach Abschluss einer maximalen Schreibperiode weiterhin ausgeführt wird.

7. Verfahren nach einem der Ansprüche 1 bis 6, in dem die zumindest partielle Initialisierung der Prüfvorrichtung (CTL) die Initialisierung einer Hauptzustandmaschine (MFSM) und einer Schreibzustandmaschine (WFSM) umfasst.

8. Speicher umfassend eine Prüfvorrichtung (CTL) zum Ausführen von Befehlen für den Zugriff zum Speicher, die in einem Steuersignal (DT), das an den Speicher (MEM) angelegt ist, empfangen werden, und eine Erkennungsschaltung der Unterspannungssetzung des Speichers (PRDT), die zumindest partiell die Prüfvorrichtung nach der Unterspannungssetzung des Speichers initialisiert,
**dadurch gekennzeichnet, dass** er eine Initialisierungsschaltung (SRCT) umfasst, die ein besonderes Ereignis im Steuersignal (DT) erkennt, und zumindest partiell die Prüfvorrichtung (CTL) nach der Erkennung des besonderen Ereignisses initialisiert.

9. Speicher nach Anspruch 8, in dem sich die Initialisierungsschaltung (SRCT) zumindest partiell nach der Initialisierung der Prüfvorrichtung (CTL) reinitialisiert.

10. Speicher nach Anspruch 8 oder 9, in dem das besondere Ereignis ein Initialisierungsbefehl ist, der vom Speicher (MEM) empfangen wird.

11. Speicher nach einem der Ansprüche 8 bis 10, in dem das besondere Ereignis ein Schreib- oder Lesebefehl im Speicher (MEM) ist, der nicht mit einer Schreib- oder Leseadresse verbunden ist.

12. Speicher nach Anspruch 11, umfassend eine Schaltung (SRCT) zum Erkennen des Empfangs eines Schreiboder Lesebefehls durch den Speicher (MEM), mit anschließender Zustandsänderung eines Auswahlsignals (CS) des Speichers (MEM), bevor eine Schreib- oder Leseadresse vom Speicher empfangen wird.

13. Speicher nach einem der Ansprüche 8 bis 12, umfassend eine Verzögerungsschaltung (TMR), die zu Beginn der Ausführung eines Schreibbefehls im Speicher (MEM) ausgelöst wird, und die zumindest partiell die Prüfvorrichtung (CTL) nach Abschluss einer maximalen Schreibperiode initialisiert.

14. Speicher nach einem der Ansprüche 8 bis 13, in dem der Teil der Prüfvorrichtung (CTL), der initialisiert wird, eine Hauptzustandsmaschine (MFSM) und eine Schreibzustandsmaschine (WFSM) umfasst.
